# EUROPEAN PATENT SPECIFICATION

(11) **EP 2 948 517 B1**
(45) Date of publication and mention of the grant of the patent: **22.01.2020**
(21) Application number: 13821260.0
(22) Date of filing: 17.12.2013
(51) Int. Cl.: C09K 5/10

(54) **ELECTRONIC DEVICE COMPRISING A LIQUID COOLING MEDIUM**
ELEKTRONISCHE VORRICHTUNG UMFASSEND EIN FLÜSSIGES KÜHLMEDIUM
APPAREIL ÉLECTRONIQUE COMPRENANT UNE LIQUIDE DE REFROIDISSEMENT

(30) Priority: 24.01.2013 US 201361756020 P
(43) Date of publication of application: 02.12.2015
(73) Proprietor: Dow Global Technologies LLC, Midland, MI 48674 (US)
(72) Inventor: FLORY, Anny, L., Philadelphia, PA 19130 (US); ESSEGHIR, Mohamed, Lawrenceville, NJ 08648 (US)
(74) Representative: Boult Wade Tennant LLP
(86) International application number: PCT/US2013/075674
(87) International publication number: WO 2014/116370

(56) References cited:
- EP-A2- 1 304 704
- WO-A1-2011/090685
- WO-A1-2013/049182
- DE-U1-202005 000 007
- US-A- 6 117 827
- US-A1- 2009 270 644
- US-A1- 2011 017 454
- US-A1- 2011 291 059
- US-A1- 2012 043 505

## Description

### FIELD

Various embodiments of the present invention relate to liquid cooling mediums employed to immersion-cool electronic hardware devices, such as data centers. Other aspects of the invention concern liquid cooling mediums having a balance of flash point and viscosity.

### INTRODUCTION

Enterprise Data Center ("EDC") facilities are physical locations housing multiple servers. Servers are generally stacked in racks in which are also mounted various computing devices, such as hard-drive arrays, network routers, data acquisition equipment, and power supplies. To deliver consistent and reliable performance, a primary goal for EDCs is adequate temperature control of the various heat generating components of the rack. Traditionally, the racks have been cooled by forced-air convection using air circulating devices, such as fans, selectively placed to maximize air flow. Air within the EDC usually circulates through a heat exchanger for cooling the air (a vapor-cycle refrigeration or chilled water coil) before entering the rack. In some EDCs, the heat exchanger is mounted at the rack to provide a rack-level cooling of the air that enters the server.

In 2005, EDCs in the United States accounted for about 1.2 % of all electricity consumed, and was expected to double by 2011. It has furthermore been estimated that the EDC population globally, if combined, would be the 6^{th} largest energy-consuming community in the world. More than one third of EDC electricity consumption is dedicated to cooling. In addition to the high impact of cooling costs on the overall EDC budget and the trend to reduce greenhouse gas emissions, energy efficiency optimization has become critical with the chiller cooling capacity approaching maximum utilization. In addition, further expansion of the EDCs will require major investment in cooling capacity expansion. Accordingly, although advancements have been made in the field of electronic hardware device cooling, improvements are still desired.

US-A-2009/270644 discloses a base agent for electrical insulating oils, characterized by comprising as a main component an esterified product between a linear or branched, saturated or unsaturated fatty acid having 6 to 14 carbon atoms and glycerine.

US-A-2011/291059 discloses a dielectric fluid composition characterized in that it comprises 60 % to 80 % in weight of mono-saturated fatty acid; of 2 % to 23 % in weight of di-unsaturated fatty acid; of 0.5 to 7 % in weight of tri-unsaturated fatty acid; and of 5% to 8% in weight of saturated fatty acid; wherein said dielectric fluid is free of external antioxidants and comprising the properties of: a dielectric strength of 40 kV to 70 kV at a separation of 2 mm; a dielectric constant of 2.5 to 3.1 at 25°C; and a dissipation factor of 0.05 % to 0.15 % at 25°C.

WO-A-2011/090685 discloses a dielectric fluid comprising an algae oil comprising a natural algae antioxidant.

US-A-2011/017454 discloses a method and apparatus of heat dissipaters for electronic components downhole tools.

### SUMMARY

The current invention concerns an apparatus comprising:
(a) an electronic hardware device; and
(b) a liquid cooling medium,
wherein said electronic hardware device is at least partially submerged in said liquid cooling medium,
wherein said liquid cooling medium comprises saturated medium chain triglycerides which consists of triglycerides having a fatty acid carbon chain length of 8 carbon atoms in an amount ranging from 50 to 60 weight percent based on the entire medium chain triglyceride weight and triglycerides having a fatty acid carbon chain length of 10 carbon atoms in an amount ranging from 40 to 50 weight percent based on the entire medium chain triglyceride weight; and
wherein said electronic hardware device is a computer device or computer component.

### DETAILED DESCRIPTION

Various embodiments of the present invention concern an apparatus comprising an electronic hardware device at least partially submerged in a liquid cooling medium, where the liquid cooling medium has a certain combination of properties. In various embodiments, the liquid cooling medium can have a flash point of at least 190 °C while simultaneously having a viscosity of 0.27 cm²/s (27 centistokes ("cSt")) or less.

### Liquid Cooling Medium

The term "liquid cooling medium" denotes a composition that is liquid at room temperature and standard pressure which is suitable for use as an immersion coolant for an electronic hardware device, such as a server. As known in the art, liquid cooling mediums generally have low viscosity, are non-toxic, chemically inert, and do not promote corrosion of equipment in which the liquid cooling medium is employed. Additionally, liquid cooling mediums may generally have higher heat capacities relative to other cooling mediums, such as air (e.g., 1.67 joules per gram per Kelvin ("J/g/K") compared to 1.01 J/g/K).

As noted above, the liquid cooling medium can have a flash point of at least 190 °C. In various embodiments, the liquid cooling medium can have a flash point of at least 192 °C, at least 195 °C, at least 200 °C, or at least 205 °C. Furthermore, in any one of such embodiments, the liquid cooling medium can have a flash point up to 300 °C, up to 280 °C, or up to 270 °C. Flash points provided herein are determined according to ASTM International ("ASTM") method D92 using a Cleveland open cup apparatus. In this method, about 70 milliliters ("mL") of test specimen is filled into a test cup. The temperature of the specimen is increased quickly initially and then slowly and at a constant rate close to the flash point. A test flame is passed across the cup at specified intervals. The flash point corresponds to the lowest liquid temperature at which application of the test flame leads to the ignition of the vapors of the test specimen. For the fire point determination (discussed below), the test continues until the test flame leads to ignition and also sustains burning for a minimum of 5 seconds.

As noted above, the liquid cooling medium can have a viscosity of 0.27cm²/s (27 cSt) or less. In various embodiments, the liquid cooling medium can have a viscosity of less than 0.27cm²/s (27 cSt), less than 0.25cm²/s (25 cSt), less than 0.23cm²/s (23 cSt), less than 0.20cm²/s (20 cSt), less than 0.18cm²/s (18 cSt), or less than 0.15cm²/s (15 cSt). Furthermore, in any one of such embodiments, the liquid cooling medium can have a viscosity of at least 0.05cm²/s (5 cSt), at least 0.07cm²/s (7 cSt), or at least 0.10cm²/s (10 cSt). Viscosities provided herein are determined according to ASTM D445 test method for kinematic viscosity at a temperature of 40 °C. In this method, the time for a fixed volume of fluid to flow under gravity through the capillary of a calibrated viscometer is measured at a controlled temperature. The kinematic viscosity is defined as the product of the measured flow time and the calibration constant of the viscometer.

As noted above, in various embodiments, the liquid cooling medium can have a combination of certain flash points and viscosities. Thus, in one or more embodiments, the liquid cooling medium can have a flash point of at least 190 °C, at least 192 °C, at least 195 °C, at least 200 °C, or at least 205 °C, while also having a viscosity of 0.27cm²/s (27 cSt) or less, or less than 0.27cm²/s (27 cSt), less than 0.25cm²/s (25 cSt), less than 0.23cm²/s (23 cSt), less than 0.20cm²/s (20 cSt), less than 0.18cm²/s (18 cSt), or less than 0.15cm²/s (15 cSt). In any of such embodiments, the liquid cooling medium can have a flash point up to 300 °C, up to 280 °C, or up to 270 °C, while having a viscosity of at least 0.05cm²/s (5 cSt), at least 0.07cm²/s (7 cSt), or at least 0.10cm²/s (10 cSt).

In various embodiments, the liquid cooling medium can have a fire point of at least 210 °C, at least 215 °C, or at least 220 °C. In such embodiments, the liquid cooling medium can have a fire point up to 320 °C, up to 310 °C, up to 300 °C, or up to 290 °C. Fire points are determined herein according to ASTM D92, as described above.

In various embodiments, the liquid cooling medium can have a thermal conductivity ranging from 0.12 to 0.14 watts per meter Kelvin ("W/m·K"). Thermal conductivity is determined at 40 °C according to procedure provided in the Test Methods section, below.

Any liquid cooling medium having the above-described properties can be employed in the various embodiments described herein. As noted above, in certain embodiments, the liquid cooling medium can comprise medium-chain triglycerides ("MCTs"). As known in the art, a "triglyceride" is a triester of glycerol and three fatty acids, and triglycerides are often found in natural sources, such as animal fats and vegetable oils. The term "medium chain" denotes triglycerides having fatty acid carbon-chain lengths ranging from 6 carbon atoms to 12 carbon atoms, including the carbonyl carbon. Thus, for example, MCTs can be triesters of glycerol and fatty acids selected from the group consisting of caproic acid (C6), caprylic acid (C8), capric acid (C10), and lauric acid (C12). In various embodiments, the MCTs are saturated (i.e., containing no carbon-carbon double bonds), although trace amounts of unsaturated compounds (e.g., less than 10 parts per million) are acceptable. In an embodiment, MCTs suitable for use can have an average fatty acid carbon chain length in the range of from 8 to 10 carbon atoms. Additionally, the MCTs, when either used alone or as a component in a multi-component liquid cooling medium, can comprise free fatty acids of less than 1 weight percent ("wt%"), less than 0.5 wt%, or less than 0.01 wt%, based on the entire liquid cooling medium weight.

The MCTs comprise a mixture of C8 triglycerides and C10 triglycerides. The C8 triglycerides constitute in the range of from 50 to 60 wt% of all MCTs based on the entire MCT weight. Additionally, the C10 triglycerides constitute in the range of from 40 to 50 wt% of all MCTs based on the entire MCT weight. In an embodiment, the MCT can be a blend of C8 and C10 triglycerides comprising 56 wt% C8 triglycerides and 44 wt% C10 triglycerides.

Examples of commercially available MCTs include the NEOBEE™ line of MCTs (e.g., NEOBEE™ 1053 and NEOBEE™ M-20) available from Stepan Company, Northfield, IL, USA.

In various embodiments, the liquid cooling medium can comprise a mixture of any one or more of the above-described MCTs and at least one mineral oil. As used herein, "mineral oil" denotes a mixture of primarily alkanes generally ranging from C15 to C40 derived from a non-vegetable source, such as petroleum. Mineral oils generally have low flash points, ranging from about 140 °C up to 185 °C. Thus, mineral oils alone are not generally desirable for use as liquid cooling mediums. However, in combination with MCTs, mineral oils can combine to form a liquid cooling medium having the above-described properties. In various embodiments, the mineral oil selected for combination with an MCT has a flash point near the upper limit typically found in mineral oils, such as from 175 to 185 °C, from 180 to 185 °C, or about 185 °C.

When a mixture of MCTs and mineral oil is used as the liquid cooling medium, the MCTs can constitute in the range of from 10 to 90 wt%, from 15 to 85 wt%, from 20 to 80 wt%, or from 40 to 60 wt% of the liquid cooling medium based on the entire liquid cooling medium weight. Additionally, the mineral oil can constitute in the range of from 10 to 90 wt%, from 15 to 85 wt%, from 20 to 80 wt%, or from 40 to 60 wt% of the liquid cooling medium based on the entire liquid cooling medium weight. In various embodiments, the MCTs and mineral oil can be present in the liquid cooling medium at a weight ratio ranging from 2:1 to 6:1, from 3:1 to 5:1, or about 4:1 MCT-to-mineral oil.

Examples of suitable commercially available mineral oils include UNIVOLT™ N 61B, produced by ExxonMobil Chemical Company, Houston, TX, USA; or DIALA™ AX, produced by Shell Oil Company, Houston, TX, USA.

In various embodiments, the liquid cooling medium can comprise a mixture of any one or more of the above-described MCTs and at least one synthetic ester. As used herein, "synthetic ester" denotes a fluid produced by the reaction of an alcohol with an organic (e.g., carboxylic) acid. Synthetic esters generally have higher flash points, but may suffer from unacceptably high viscosity (e.g., 0.28cm²/s (28 cSt) or more at 40 °C). Thus, synthetic esters alone are not generally desirable for use as liquid cooling mediums. However, in combination with MCTs, synthetic esters can combine to form a liquid cooling medium having the above-described properties. In various embodiments, the synthetic ester selected for combination with MCTs has a viscosity near the lower limit typically found in synthetic esters, such as from 0.28cm²/s to 0.38cm²/s (28 to 38 cSt), from 0.28cm²/s to 0.33cm²/s (28 to 33 cSt), or about 0.28cm²/s (28 cSt).

When a mixture of MCTs and synthetic ester is used as the liquid cooling medium, the MCTs can constitute in the range of from 10 to 90 wt%, from 15 to 85 wt%, from 20 to 80 wt%, or from 40 to 60 wt% of the liquid cooling medium based on the entire liquid cooling medium weight. Additionally, the synthetic ester can constitute in the range of from 10 to 90 wt%, from 15 to 85 wt%, from 20 to 80 wt%, or from 40 to 60 wt% of the liquid cooling medium based on the entire liquid cooling medium weight.

An example of a suitable commercially available synthetic ester includes MIDEL™ 7131, produced by M&I Materials Ltd., Manchester, UK.

In various embodiments, the liquid cooling medium can comprise a mixture of any one or more of the above-described MCTs and at least one vegetable oil. As used herein, "vegetable oil" denotes a composition primarily comprised of triglycerides, which are triesters of three fatty acids with glycerol, but generally comprise longer-chain fatty acid moieties (e.g., C18) as compared to MCTs. Vegetable oils generally have higher flash points, but may suffer from unacceptably high viscosity (e.g., 0.40cm²/s (40 cSt) or more at 40 °C). Thus, vegetable oils alone are not generally desirable for use as liquid cooling mediums. However, in combination with MCTs, vegetable oils can combine to form a liquid cooling medium having the above-described properties. In various embodiments, the vegetable oil selected for combination with an MCT has a viscosity near the lower limit typically found in vegetable oils, such as from 0.30cm²/s to 0.50cm²/s (30 to 50 cSt), from 0.35cm²/s to 0.45cm²/s (35 to 45 cSt), or about 0.40cm²/s (40 cSt).

When a mixture of MCTs and vegetable oil is used as the liquid cooling medium, the MCTs can constitute in the range of from 10 to 90 wt%, from 15 to 85 wt%, from 20 to 80 wt%, or from 40 to 60 wt% of the liquid cooling medium based on the entire liquid cooling medium weight. Additionally, the vegetable oil can constitute in the range of from 10 to 90 wt%, from 15 to 85 wt%, from 20 to 80 wt%, or from 40 to 60 wt% of the liquid cooling medium based on the entire liquid cooling medium weight. In various embodiments, the MCTs and vegetable oil can be present in the liquid cooling medium at a weight ratio ranging from 3:1 to 1:1 MCT-to-vegetable oil.

Specific types of vegetable oils suitable for use herein include, but are not limited to, sunflower oil, canola oil, and soybean oil. In an embodiment, the vegetable oil is sunflower oil.

In one or more embodiments, the liquid cooling medium can comprise a polyalkylene glycol. "Polyalkylene glycol" denotes an oligomer or polymer primarily comprised of polymerized alkylene oxide (e.g., ethylene oxide). Examples of suitable polyalkylene oxides include polyethylene oxide, polypropylene oxide, and polybutylene oxide. When a polyalkylene glycol is employed in the liquid cooling medium, it can constitute at least 50 wt%, at least 70 wt%, at least 90 wt%, at least 99 wt%, or all of the liquid cooling medium, based on the entire liquid cooling medium weight.

Suitable polyalkylene glycols can have a weight averaged molecular weight ("Mw") ranging from 500 to 1,000 g/mol, from 600 to 800 g/mol, or from 650 to 750 g/mol. In an embodiment, the polyalkylene glycol can have an Mw of about 700 g/mol. Additionally, suitable polyalkylene glycols can have a density ranging from 0.80 to 1.0 g/mL, from 0.85 to 0.98 g/mL, from 0.90 to 0.94 g/mL, or from 0.91 to 0.93 g/mL. In an embodiment, the polyalkylene glycol can have a density of about 0.92 g/mL.

Examples of suitable commercially available polyalkylene glycols include UCON™ OSP and Synalox OA produced by The Dow Chemical Company, Midland, MI, USA; and PLURIOL™ polyalkylene glycols, available from BASF Corporation, Florham Park, NJ, USA.

In one or more embodiments, the liquid cooling medium can comprise a paraffinic oil. "Paraffinic oil" denotes a class of mineral oils based on n-alkanes, having a low content of aromatic hydrocarbons. Examples of suitable paraffinic oils include any paraffinic oil meeting the above-described flash point and viscosity requirements. When a paraffinic oil is employed in the liquid cooling medium, it can constitute at least 50 wt%, at least 70 wt%, at least 90 wt%, at least 99 wt%, or all of the liquid cooling medium, based on the entire liquid cooling medium weight.

Examples of suitable commercially available paraffinic oils include PARAMOUNT™ 1001 and PARALUX™ 1001, both produced by Chevron Corporation, San Ramon, CA, USA.

In any of the foregoing embodiments, when the liquid cooling medium employed is a blend of two or more components, the blend can be prepared by any known or hereafter discovered methods in the art for blending two liquid components. For example, multiple liquid components can be mechanically blended using stirrers. In various embodiments, the two or more components making up the liquid cooling medium are miscible.

### Electronic Hardware Device

As noted above, the liquid cooling medium is employed to cool an electronic hardware device, such as in a data center. The electronic hardware device is a computer device or component (e.g., a computer server). Specific examples of electronic hardware devices that can be employed include computer servers, server motherboards and microprocessors.

In order to effect such cooling, the electronic hardware device is placed in physical contact with the liquid cooling medium. The electronic hardware device is at least partially, or completely submerged into the liquid cooling medium.

Specific cooling systems employing at least partial submersion in the liquid cooling medium are varied. By way of example, in one embodiment, the electronic hardware device is completely immersed in an individually sealed bath of liquid cooling medium. In this embodiment, the liquid cooling medium passively transfers heat away from the electronic hardware device to an integrated heat exchanger formed by the wall of the bath where water is continuously circulated and cooled. In another embodiment, a server motherboard can be completely immersed in an individually sealed bath of liquid cooling medium. The liquid cooling medium is then pumped through sealed server cases and circulated through a radiator attached to the pump acting as a heat exchanger. In still another embodiment, an entire rack of servers can be immersed in a tank filled with liquid cooling medium. In this embodiment, the liquid cooling medium can circulate through an outdoor radiator where the heat is exchanged directly to exterior air.

Specific examples of such cooling systems can be found, for example, in U.S. Patent No. 7,403,392 to Hardcore Computer, Inc, and U.S. Published Patent Application No. 2011/0132579 to Green Revolution Cooling, Inc.

### TEST METHODS

### Fire Point

Fire point is determined according to ASTM D92.

### Flash Point

Flash point is determined according to ASTM D92.

### Thermal Conductivity

Thermal conductivity is determined according to ASTM D5930 by subjecting the sample to an axial temperature gradient. By measuring the temperature difference across the sample along with the output from the heat flux transducer, thermal conductivity of the sample can be determined.

### Viscosity

Viscosity is determined according to ASTM D445 at 40 °C.

### EXAMPLES

### Example 1 - Comparative Samples Testing

Analyze three Comparative Samples (CS A-C) according to the above-described Test Methods. CS A is 100 wt% mineral oil sold under the trade name UNIVOLT™ N 61B, which is available from ExxonMobil Chemical Company, Houston, TX, USA. UNIVOLT™ N 61B is a 90 to 100 % hydrogenated light naphthenic distillate. CS B is 100 wt% sunflower oil obtained from Saipol Agro Industrial Company, Paris, France. CS C is 100 wt% of a synthetic ester sold under the trade name MIDEL™ 7131, which is produced by M&I Materials Ltd., Manchester, UK. MIDEL™ 7131 comprises fatty acid, C5-10 (linear and branched), mixed esters with pentaerythritol. Results of the analyses are provided in Table 1, below.

**Table 1 - CS A-C Properties**

| | **CS A** | **CS B** | **CS C** |
|---|---|---|---|
| **Viscosity (cm²/s) ((cSt)) at 40 °C** | 0.11 (11.0) | 0.408 (40.8) | 0.288 (28.8) |
| **Flash point (°C)** | 154 | 318 | 262 |
| **Fire point (°C)** | 164 | 358 | 300 |
| **Thermal conductivity (W/m·K) at 40 °C** | 0.11 | 0.14 | 0.14 |

As can be seen from the results shown in Table 1, while mineral oil (CS A) provides desirably low viscosity, it also exhibits an undesirably low flash point. Conversely, sunflower oil (CS B) and synthetic ester (CS C) alone have desirably high flash points, but unacceptably high viscosities.

### Example 2 - Medium-Chain Triglycerides

Analyze two Samples (S1 and S2) according to the above-described Test Methods. S1 is 100 wt% medium-chain triglycerides, sold under the trade name NEOBEE™ 1053 by Stepan Company, Northfield, IL, USA. NEOBEE™ 1053 is a saturated caprylic (C8) / capric (C10) triglyceride. NEOBEE™ 1053 contains 56 percent saturated caprylic (C8) fatty acid chains, and 44 percent saturated capric (C10) fatty acid chains. S2 (Comparative Sample) is 100 wt% medium-chain triglycerides sold under the trade name NEOBEE™ M-20 by Stepan Company, Northfield, IL, USA. NEOBEE™ M-20 contains 1 percent C6 fatty acid chains, 1 percent C12 fatty acid chains, 68 percent C8 fatty acid chains, and 30 percent C10 fatty acid chains. Results of the analyses are provided in Table 2, below.

**Table 2 - S1-S2 Properties**

| | **S1** | **S2** |
|---|---|---|
| **Viscosity (cm²/s) ((cSt))** | 0.148 (14.8) | 0.06 (6.0) |
| **Flash point (°C)** | 248 | 190 |
| **Fire point (°C)** | 282 | 210 |
| **Thermal conductivity (W/m·K)** | 0.14 | 0.14 |

As shown in Table 2, both of the MCT samples provide superior viscosity (e.g., less than about 0.28 cm²/s (28 cSt)) while simultaneously providing excellent flash points (e.g., at least about 190 °C).

### Example 3 - Mixtures of MCT with Mineral Oil

Prepare two Samples (S3-S4) containing MCT and mineral oil according to the compositions provided in Table 3, below. Samples S3-S4 are prepared by mixing the two components via magnetic stirring in a closed jar at 50 °C for 15 minutes. The MCT employed in each of Samples S3 and S4 is NEOBEE™ 1053, as described above in Example 2. The mineral oil in Samples S3 and S4 is the mineral oil supplied by Univolt, as described above in Example 1.

Analyze Samples S3 and S4 according to the Test Methods provided above. Results are provided in Table 3, below.

**Table 3 - S3-S4 Compositions and Properties**

| | **S3** | **S4** |
|---|---|---|
| **Mineral Oil (Univolt) (wt%)** | 20 | 40 |
| **MCT (wt%)** | 80 | 60 |
| **Total:** | 100 | 100 |
| | | |
| **Viscosity (cm²/s) ((cSt))** | 0.132 (13.2) | 0.119 (11.9) |
| **Flash point (°C)** | 192 | 170 |
| **Fire point (°C)** | 222 | 184 |
| **Thermal conductivity (W/m·K)** | 0.13 | 0.13 |

As seen in Table 3, although mineral oil alone (CS A, Table 1) does not provide the appropriate combination of low viscosity and high flash point, the mixtures of MCT with mineral oil do provide such a combination. It is noted that S4 only achieved a flash point of 170 °C; however, this is a significant improvement over the flash point of the Univolt mineral oil alone, which is 154 °C, as shown by CS A in Table 1, above.

### Example 4 - Mixture of MCT with Vegetable Oil

Prepare five Samples (S5-S9) containing MCT and sunflower oil according to the compositions provided in Table 4, below. Sample S5-S9 are prepared by mixing the two components via magnetic stirring in a closed jar at 50 °C for 15 minutes. The MCT employed in Samples S5-S7 is NEOBEE™ 1053, as described above in Example 2. The MCT employed in Samples S8 (Comparative Sample) and S9 (Comparative Sample) is NEOBEE™ M-20, as described above in Example 2. The sunflower oil in Samples S5-S9 is the same as the sunflower oil described in Example 1, above.

Analyze Samples S5-S9 according to the Test Methods provided above. Results are provided in Table 4, below.

**Table 4 - S5-S9 Compositions and Properties**

| | **S5** | **S6** | **S7** | **S8** | **S9** |
|---|---|---|---|---|---|
| **Sunflower Oil (wt%)** | 40 | 25 | 50 | 25 | 50 |
| **Neobee 1053 (wt%)** | 60 | 75 | 50 | - | - |
| **Neobee M-20 (wt%)** | - | - | - | 75 | 50 |
| **Total:** | 100 | 100 | 100 | 100 | 100 |
| | | | | | |
| **Viscosity (cm²/s) ((cSt))** | 0.209 (20.9) | 0.192 (19.2) | 0.240 (24.0) | 0.097 (9.7) | 0.154 (15.4) |
| **Flash point (°C)** | 198 | 260 | 270 | 192 | 208 |
| **Fire point (°C)** | 218 | 290 | 298 | 216 | 222 |
| **Thermal conductivity (W/m·K)** | N/A | 0.14 | 0.13 | 0.13 | N/A |

As seen in Table 4, although sunflower oil alone (CS B) does not provide the appropriate combination of low viscosity and high flash point, the mixtures of MCT with sunflower oil all provide superior viscosities and flash points.

### Example 5 - Mixture of MCT with Synthetic Ester

Prepare three Samples (S10-S12) containing MCT and synthetic ester according to the compositions provided in Table 5, below. Sample S10-S12 are prepared by mixing the two components via magnetic stirring in a closed jar at 50 °C for 15 minutes. The MCT employed in Samples S10-S12 is NEOBEE™ 1053, as described above in Example 2. The synthetic ester in Samples S10-S12 is MIDEL™ 7131, as described in Example 1, above.

Analyze Samples S10-S12 according to the Test Methods provided above. Results are provided in Table 5, below.

**Table 5 - S10-S12 Compositions and Properties**

| | **S10** | **S11** | **S12** |
|---|---|---|---|
| **Midel 7131 (wt%)** | 20 | 40 | 80 |
| **Neobee 1053 (wt%)** | 80 | 60 | 20 |
| **Total:** | 100 | 100 | 100 |
| | | | |
| **Viscosity (cm²/s) ((cSt))** | 0.164 (16.4) | 0.184 (18.4) | 0.243 (24.3) |
| **Flash point (°C)** | 250 | 252 | 256 |
| **Fire point (°C)** | 288 | 288 | 296 |
| **Thermal conductivity (W/m·K)** | 0.13 | 0.13 | NA |

As seen in Table 5, although synthetic ester alone (CS C) does not provide the appropriate combination of low viscosity and high flash point, the mixtures of MCT with synthetic ester all provide superior viscosities and flash points.

### Example 6 - Polyalkylene Glycol (comparative example)

Sample 13 (S13) is 100 wt% polyalkylene glycol ("PAG"). Specifically, S13 is UCON OSP-18, an oil-soluble PAG base fluid technology from Dow Chemical. Analyze Sample S13 according to the Test Methods provided above. S13 has a viscosity of 0.18cm²/s (18.0 cSt), a flash point of 204 °C, a fire point of 240 °C, a heat capacity of 1.96 J/g/°C, and a thermal conductivity of 0.14 w/m·K.

### Example 7- Paraffinic Oil (comparative example)

Sample 14 (S14) is 100 wt% paraffinic oil. Specifically, S14 is PARAMOUNT™ 1001, available from Chevron. S14 has a viscosity of 0.204cm²/s (20.4 cSt) and a flash point of 212 °C.

## Claims

1. An apparatus comprising:
(a) an electronic hardware device; and
(b) a liquid cooling medium,
wherein said electronic hardware device is at least partially submerged in said liquid cooling medium,
wherein said liquid cooling medium comprises saturated medium chain triglycerides which consists of triglycerides having a fatty acid carbon chain length of 8 carbon atoms in an amount ranging from 50 to 60 weight percent based on the entire medium chain triglyceride weight and triglycerides having a fatty acid carbon chain length of 10 carbon atoms in an amount ranging from 40 to 50 weight percent based on the entire medium chain triglyceride weight; and
wherein said electronic hardware device is a computer device or computer component.

2. The apparatus of claim 1, wherein said saturated medium chain triglycerides constitute a first component of said liquid cooling medium, wherein said liquid cooling medium further comprises a second component selected from the group consisting of a mineral oil, a vegetable oil, a synthetic ester, and mixtures of two or more thereof.

3. The apparatus of claim 2, wherein said first component constitutes at least 15 weight percent of said liquid cooling medium, based on the total liquid cooling medium weight.

4. The apparatus of claim 1, wherein said liquid cooling medium has a flash point of at least 190 °C, as determined according to ASTM D92, wherein said liquid cooling medium has a viscosity of 0.27cm²/s (27 centistokes ("cSt")) or less at 40 °C, as determined according to ASTM D445, wherein said liquid cooling medium has a fire point of at least 210 °C, as determined according to ASTM D92, wherein said liquid cooling medium has a thermal conductivity in the range of from 0.12 to 0.14 W/m·K, as determined according to ASTM D5930.

5. The apparatus of claim 4, wherein said liquid cooling medium has a flash point in the range of from 192 to 300 °C, as determined according to ASTM D92.

6. The apparatus of claim 4, wherein said liquid cooling medium has a viscosity in the range of from 0.05 to 0.25cm²/s (5 to 25 cSt) at 40 °C, as determined according to ASTM D445.

7. The apparatus of claim 1, wherein said electronic hardware device is selected from the group consisting of computer servers, server motherboards, and microprocessors.

## Patentansprüche

1. Ein Apparat, der Folgendes beinhaltet:
(a) eine elektronische Hardwarevorrichtung; und
(b) ein flüssiges Kühlmittel,
wobei die elektronische Hardwarevorrichtung mindestens teilweise in das flüssige Kühlmittel getaucht ist,
wobei das flüssige Kühlmittel gesättigte mittelkettige Triglyceride, das aus Triglyceriden mit einer Fettsäure-Kohlenstoffkettenlänge von 8 Kohlenstoffatomen in einer Menge im Bereich von 50 bis 60 Gewichtsprozent, bezogen auf das Gesamtgewicht der mittelkettigen Triglyceride, und Triglyceriden mit einer Fettsäure-Kohlenstoffkettenlänge von 10 Kohlenstoffatomen in einer Menge im Bereich von 40 bis 50 Gewichtsprozent, bezogen auf das Gesamtgewicht der mittelkettigen Triglyceride, besteht, beinhaltet; und wobei die elektronische Hardwarevorrichtung eine Computervorrichtung oder eine Computerkomponente ist.

2. Apparat gemäß Anspruch 1, wobei die gesättigten mittelkettigen Triglyceride eine erste Komponente des flüssigen Kühlmittels ausmachen, wobei das flüssige Kühlmittel ferner eine zweite Komponente beinhaltet, die aus der Gruppe ausgewählt ist, die aus einem Mineralöl, einem pflanzlichen Öl, einem synthetischen Ester und Mischungen von zwei oder mehr davon besteht.

3. Apparat gemäß Anspruch 2, wobei die erste Komponente mindestens 15 Gewichtsprozent des flüssigen Kühlmittels, bezogen auf das Gesamtgewicht des flüssigen Kühlmittels, ausmacht.

4. Apparat gemäß Anspruch 1, wobei das flüssige Kühlmittel einen Flammpunkt von mindestens 190 °C, wie gemäß ASTM D92 bestimmt, aufweist, wobei das flüssige Kühlmittel bei 40 °C eine Viskosität von 0,27 cm²/s (27 Centistoke ("cSt")) oder weniger, wie gemäß ASTM D445 bestimmt, aufweist, wobei das flüssige Kühlmittel einen Brennpunkt von mindestens 210 °C, wie gemäß ASTM D92 bestimmt, aufweist, wobei das flüssige Kühlmittel eine Wärmeleitfähigkeit in dem Bereich von 0,12 bis 0,14 W/m·K, wie gemäß ASTM D5930 bestimmt, aufweist.

5. Apparat gemäß Anspruch 4, wobei das flüssige Kühlmittel einen Flammpunkt in dem Bereich von 192 bis 300 °C, wie gemäß ASTM D92 bestimmt, aufweist.

6. Apparat gemäß Anspruch 4, wobei das flüssige Kühlmittel bei 40 °C eine Viskosität in dem Bereich von 0,05 bis 0,25 cm²/s (5 bis 25 cSt), wie gemäß ASTM D445 bestimmt, aufweist.

7. Apparat gemäß Anspruch 1, wobei die elektronische Hardwarevorrichtung aus der Gruppe ausgewählt ist, die aus Computerservern, Serverhauptplatinen und Mikroprozessoren besteht.

## Revendications

1. Un appareil comprenant :
(a) un dispositif de matériel informatique électronique ; et
(b) un milieu de refroidissement liquide,
dans lequel ledit dispositif de matériel informatique électronique est au moins en partie immergé dans ledit milieu de refroidissement liquide,
dans lequel ledit milieu de refroidissement liquide comprend des triglycérides à chaîne moyenne saturés, lequel consiste en triglycérides ayant une longueur de chaîne de carbone d'acide gras de 8 atomes de carbone en une quantité comprise dans la gamme allant de 50 à 60 pour cent en poids rapporté au poids tout entier de triglycérides à chaîne moyenne et en triglycérides ayant une longueur de chaîne de carbone d'acide gras de 10 atomes de carbone en une quantité comprise dans la gamme allant de 40 à 50 pour cent en poids rapporté au poids tout entier de triglycérides à chaîne moyenne ; et
dans lequel ledit dispositif de matériel informatique électronique est un dispositif informatique ou un composant informatique.

2. L'appareil de la revendication 1, dans lequel lesdits triglycérides à chaîne moyenne saturés constituent un premier composant dudit milieu de refroidissement liquide, ledit milieu de refroidissement liquide comprenant en outre un deuxième composant sélectionné dans le groupe consistant en une huile minérale, une huile végétale, un ester synthétique, et des mélanges de deux de ceux-ci ou plus.

3. L'appareil de la revendication 2, dans lequel ledit premier composant constitue au moins 15 pour cent en poids dudit milieu de refroidissement liquide, rapporté au poids total du milieu de refroidissement liquide.

4. L'appareil de la revendication 1, dans lequel ledit milieu de refroidissement liquide a un point d'éclair d'au moins 190 °C, tel que déterminé selon l'ASTM D92, dans lequel ledit milieu de refroidissement liquide a une viscosité de 0,27 cm²/s (27 centistokes (« cSt »)) ou moins à 40 °C, tel que déterminé selon l'ASTM D445, dans lequel ledit milieu de refroidissement liquide a un point de feu d'au moins 210 °C, tel que déterminé selon l'ASTM D92, dans lequel ledit milieu de refroidissement liquide a une conductivité thermique comprise dans la gamme allant de 0,12 à 0,14 W/m·K, tel que déterminé selon l'ASTM D5930.

5. L'appareil de la revendication 4, dans lequel ledit milieu de refroidissement liquide a un point d'éclair compris dans la gamme allant de 195 à 300 °C, tel que déterminé selon l'ASTM D92.

6. L'appareil de la revendication 4, dans lequel ledit milieu de refroidissement liquide a une viscosité comprise dans la gamme allant de 0,05 à 0,25 cm²/s (5 à 25 cSt) à 40 °C, tel que déterminé selon l'ASTM D445.

7. L'appareil de la revendication 1, dans lequel ledit dispositif de matériel informatique électronique est sélectionné dans le groupe consistant en serveurs informatiques, cartes mères de serveurs, et microprocesseurs.
